# EUROPÄISCHE PATENTSCHRIFT

(11) **EP 1 860 708 B1**
(45) Veröffentlichungstag und Bekanntmachung des Hinweises auf die Patenterteilung: **22.07.2015**
(21) Anmeldenummer: 07010084.7
(22) Anmeldetag: 21.05.2007
(51) Int. Cl.: H01L 35/00, H01L 35/32, H02N 11/00, G04C 10/00

(54) **Thermogenerator**
Thermoelectric generator
Generateur thermoélectrique

(30) Priorität: 23.05.2006 DE 102006024167
(43) Veröffentlichungstag der Anmeldung: 28.11.2007
(60) Teilanmeldung: 11153411.1
(73) Patentinhaber: EnOcean GmbH, 82041 Oberhaching (DE)
(72) Erfinder: Schmidt, Frank, 82054 Altkirchen (DE)
(74) Vertreter: Epping - Hermann - Fischer

(56) Entgegenhaltungen:
- EP-A- 0 898 355
- EP-A- 0 919 887
- EP-A- 0 935 334
- WO-A-00/17997
- WO-A-01/91315
- WO-A-02/095707
- GB-A- 2 017 359
- US-A- 4 165 477
- US-A- 4 245 286
- US-A- 5 705 770
- US-A- 5 769 622
- US-B1- 6 232 543
- AMIRTHARAJAH R ET AL: "SELF-POWERED SIGNAL PROCESSING USING VIBRATION-BASED POWER GENERATION" IEEE JOURNAL OF SOLID-STATE CIRCUITS, IEEE SERVICE CENTER, PISCATAWAY, NJ, US, Bd. 33, Nr. 5, 1. Mai 1998 (1998-05-01), Seiten 687-695, XP000785001 ISSN: 0018-9200

## Beschreibung

Die Erfindung betrifft einen Thermogenerator und ein Verfahren zur Wandlung von thermischer Energie in elektrische Energie.

Thermische Energie in elektrische Energie zu wandeln, ist ein seit langem allgemein bekannter Vorgang. Beispielhaft seien die zahlreichen Kraftwerke der Stromerzeuger genannt. Diesem Prozess liegt eine Wandlung der thermischen Energie in Bewegungsenergie zugrunde. Die Bewegungsenergie wird wiederum in elektrische Energie gewandelt. Um diese Prozesse zu betreiben und in lohnenswerter Menge elektrische Energie durch diese Prozesse zu erzeugen, ist eine große Menge thermischer Energie erforderlich, die sich durch einen hohen Temperaturunterschied von mehreren 100°K von den mit thermischer Energie beladenen Medien oder Körpern zur Umgebungstemperatur auszeichnet. Thermische Energie geringer Temperaturniveaus ist mit den oben genannten Prozessen nicht in elektrische Energie zu wandeln. Um thermische Energie geringerer Niveaus in elektrische Energie zu wandeln, sind thermoelektrische Prozesse bekannt. Solche thermoelektrischen Prozesse sind davon geprägt, nur sehr geringe elektrische Spannungen oder nur sehr geringe elektrische Ströme erzeugen zu können.

Aus diesem Grund finden thermoelektrische Prozesse in der Messtechnik Verwendung, wobei die erzeugten und abhängig von den zugrunde liegenden Effekten auch sehr geringen, elektrischen Spannungen als Referenz zu einer bestimmten Temperatur oder Temperaturdifferenz verwendet werden. Solche thermoelektrischen Prozesse werden demzufolge bislang nur zur Messung der Temperatur herangezogen.

Nachteilig ist, dass bislang mit auf thermoelektrischen Effekten basierenden thermoelektrischen Wandlern elektrische Verbraucher und auch halbleiterbasierte elektrische Verbraucher nur sehr schwer zu betreiben sind. Dies begründet sich in den oben genannten Effekten von zu geringen elektrischen Spannungen oder elektrischen Strömen.

Zur Wandlung von thermischer Energie geringen Niveaus in elektrische Energie, welche auch zu einer weiteren Nutzung einem elektrischen Verbraucher zugeführt werden kann und damit nicht nur zur Temperaturbestimmung herangezogen wird, ist bislang keine praktikable und einfache Lösung bekannt. Thermische Energie geringen Niveaus wird als solche zur Energiewandlung nicht herangezogen. Dies auch insbesondere deshalb, da thermische Energie geringen Niveaus nicht zuverlässig dann in ausreichender Menge zur Verfügung steht, wenn elektrische Energie benötigt wird. Als Beispiel dafür ist thermische Energie in Form von Abwärme von Maschinen oder Ähnlichem zu nennen.

Die Druckschriften US 4 165 477 A, US 5 769 622 A, EP 0 935 334 A2, GB 2 017 359 A sowie US 6 232 543 B1 beschreiben jeweils elektrische Geräte und Systeme, bei denen thermische Energie in elektrische Spannung gewandelt und diese zum Betrieb der Geräte bzw. Systeme ausgenutzt wird. Nachteilig an diesen Lösungen ist, dass sie für eine Wandlung von thermischer Energie geringen Niveaus zum Betrieb der Geräte nicht geeignet sind. Vielmehr schlagen einige der genannten Lehren weitere Energiequellen vor, die für einen Betrieb der Geräte unterstützend herangezogen werden können, z.B. solargenerierte Energie.

Es ist somit die Aufgabe der Erfindung, Wärmeenergie von geringem Niveau beziehungsweise von geringen Temperaturdifferenzen zur Umgebung für elektrische Verbraucher nutzbar zu machen.

Diese Aufgabe wird erfindungsgemäß durch einen Thermogenerator nach Anspruch 1 bzw. ein Verfahren zur Wandlung thermischer Energie in elektrische Energie nach Anspruch 18 gelöst und mit den in den jeweils untergeordneten Patentansprüchen beschriebenen Merkmalen bzw. Maßnahmen in vorteilhafter Weise weitergebildet.

Dabei ist gemäß einem ersten Aspekt ein Thermogenerator vorgesehen, mit einer ersten elektrischen Spannungsquelle mit einem ersten Spannungsausgang und einer zweiten elektrischen Spannungsquelle mit einem zweiten Spannungsausgang. Die erste elektrische Spannungsquelle ist aus einem ersten thermoelektrischen Element gebildet. Ferner ist ein dritter Spannungsausgang vorgesehen, der mit dem ersten Spannungsausgang und dem zweiten Spannungsausgang gekoppelt ist.

Der Thermogenerator weist ferner einen Spannungswandler auf, der einen ersten Spannungseingang aufweist, welcher mit dem ersten Spannungsausgang verbunden ist und einen zweiten Spannungseingang aufweist, welcher mit dem zweiten Spannungsausgang verbunden ist. Der Spannungswandler ist dabei dazu eingerichtet, an seinem dritten Spannungsausgang ein von dem ersten Spannungseingang verschiedenes Spannungsniveau abzugeben. Damit ist erreichbar, dass Spannungsniveaus, die das vom Verbraucher benötigte Niveau unterschreiten, auf ein höheres Niveau wandelbar sind. Ebenso sind Spannungsniveaus, die das vom Verbraucher benötigte Niveau überschreiten, auf ein niedrigeres Niveau wandelbar. Unabhängig von der durch die Thermoelemente gelieferten Spannung ist somit eine für den Verbraucher geeignete elektrische Spannung herstellbar.

Zudem weist der Thermogenerator eine Startvorrichtung zum Starten des Spannungswandlers über ein Startsignal auf, wobei die zweite elektrische Spannungsquelle über ihren zweiten Spannungsausgang die Startvorrichtung betreibt. Die Startvorrichtung hat den Vorteil, dass sie, betrieben durch eine von der zweiten elektrischen Spannungsquelle bereitgestellte Spannung, den Spannungswandler und damit den Prozess der Energiewandlung starten kann. Dadurch können auch thermische Energien eines sehr niedrigen Niveaus an der ersten Spannungsquelle ausgenutzt und gewandelt werden, welche selbst jedoch zu niedrig wären, um den Spannungswandler zu starten.

Alternativ ist ein Verfahren zur Wandlung von thermischer Energie in elektrische Energie vorgeschlagen, bei dem mittels eines ersten thermoelektrischen Elements elektrische Spannung erzeugt wird und bei dem mittels einer zweiten Spannungsquelle elektrische Spannung zumindest zeitweise vorliegt. Mittels einer Wandlerschaltung wird die elektrische Spannung des ersten thermoelektrischen Elements auf ein höheres Spannungsniveau gewandelt. Erfindungsgemäß wird mittels der zweiten Spannungsquelle eine Startvorrichtung betrieben, wobei die Startvorrichtung ein Startsignal erzeugt, welches die Wandlerschaltung aktiviert. Auch aus einem derartigen Verfahren ergeben sich die bereits erläuterten Vorteile.

Um zu vermeiden, dass die beiden Spannungsquellen sich gegenseitig speisen, ist eine Entkopplungseinrichtung an zumindest der thermoelektrischen Spannungsquelle vorgesehen. Eine solche Entkopplungseinrichtung kann zum Beispiel durch eine Diode gebildet sein.

Als Thermoelement zur Bildung der ersten Spannungsquelle sind thermoelektrische Bauelemente verwendbar, denen ein thermoelektrischer Prozess zugrunde gelegt ist.

Ein Thermoelektrischer Prozess ist zum Beispiel der Seebeck-Effekt. Es beschreibt der Seebeck-Effekt, dass wenn in einem geschlossenen elektrischen Leiter zwei Lötstellen zwischen verschiedenen Materialien mit verschiedenen Temperaturen ausgebildet sind, ein elektrischer Strom, der so genannte Thermostrom, fließt. Dieser Thermostrom lässt sich bereits bei Temperaturdifferenzen von 1 Kelvin und darunter messen.

Die aus dem Seebeck-Effekt resultierende Thermospannung ist abhängig von den verwendeten Metallen, beziehungsweise Metallpaarungen. Der Seebeck-Effekt liegt Thermoelementen zugrunde, wobei elektrische Spannung in Abhängigkeit von einer Temperatur gebildet wird. Die damit erzeugten Spannungen sind sehr klein und als Spannungsquelle für den Betrieb weiterer elektrischer Schaltungen direkt nur dann nutzbar, wenn der Energiebedarf und Spannungsbedarf eines Verbrauchers ebenfalls sehr gering ist.

Mittels der zweiten Spannungsquelle werden in vorteilhafter Weise Spannungsschwankungen oder Versorgungslücken aufgrund wechselnder Temperaturen ausgeglichen. Damit ist ein Dauerbetrieb des Verbrauchers möglich.

Die Thermospannung eines einzelnen Thermoelementes ist sehr gering. Um die erzeugte Spannung zu erhöhen, können Thermoelemente in Serienschaltung betrieben werden. Somit sind höhere Ausgangsspannungen zu erzielen. Da jedes einzelne der Thermoelemente einen eigenen Innenwiderstand aufweist, erhöht sich durch die Serienschaltung der Thermoelemente auch der Gesamtinnenwiderstand der Thermoelemente. Somit ist eine höhere Ausgangsspannung erreichbar, jedoch verringert sich dadurch der Wirkungsgrad der ersten Spannungsquelle. Abhängig von dem angeschlossenen Verbraucher, ist die höhere Spannung von größerer Bedeutung in Bezug auf den Betrieb des Verbrauchers als der Wirkungsgrad der Spannungsquelle, welcher der Verbraucher die benötigte elektrische Energie entnimmt.

Durch einen Parallelbetrieb von Thermoelementen beziehungsweise durch eine flächenmäßig größere Ausbildung der Thermoelemente wird im Gegenzug keine höhere Spannung, jedoch ein höherer Strom erzeugt. Bei Thermoelementen wird dem zufolge ein höherer Thermostrom erzeugt. Durch die Parallelschaltung verbessert sich der Innenwiderstand in vorteilhafter Weise, da sich der Innenwiderstand der Gesamtschaltung dann vorteilhaft verringert. Abhängig von dem angeschlossenen Verbraucher ist hierbei der höhere Strom von größerer Bedeutung in Bezug auf den Betrieb des Verbrauchers.

Ein weiterer thermoelektrischer Effekt ist der Peltier-Effekt. Dieser findet in den gleichnamigen Peltier-Elementen seine Anwendung. Ein Peltier-Element besteht aus zwei dünnen keramischen Platten, zwischen denen abwechselnd viele kleine Quader aus p- und n-dotiertem Halbleitermaterial eingelötet sind. Immer zwei unterschiedliche Quader sind so miteinander verbunden, dass sie eine Serienschaltung ergeben. Der zugeführte elektrische Strom durchfließt alle Quader nacheinander. Abhängig von Stromstärke und Richtung kühlt sich eine Platte ab, während die andere sich erwärmt. Der Strom erzeugt somit eine Temperaturdifferenz zwischen den Platten. Der Peltier-Effekt ist auch umkehrbar. Kühlt man eine Seite des Peltier-Elements mittels eines aufgesetzten Kühlkörpers ab, so ergibt sich eine Temperaturdifferenz zwischen den beiden Seiten des Peltier-Elements, wodurch elektrischer Strom erzeugbar ist. Ähnlich wie bei Thermoelementen nach dem Seebeck-Effekt ist auch die dadurch gewonnene elektrische Spannung sehr gering.

Ein weiterer thermoelektrischer Effekt ist der pyroelektrische Effekt. Dieser wird durch eine Temperaturabhängigkeit der so genannten spontanen Polarisation hervorgerufen. Spontane Polarisation ist, wenn in einem Kristall eine elektrische Polarisation vorliegt, ohne dass äußerliche Einflüsse der Polarisation zugrunde liegen. Temperaturwechsel von 1 Kelvin verursachen eine Änderung des von der spontanen Polarisation verursachten elektrischen Feldes von bis zu 10⁵ V/m. Einen pyroelektrischen Effekt zeigen nur wenige Kristalle von bestimmter Struktur.

In einer vorteilhaften Ausführungsform ist die zweite elektrische Spannungsquelle aus einem ersten elektrischen Speicherelement gebildet. Wahlweise eignet sich dazu eine Batterie oder ein Akkumulator zur Speicherung von elektrischer Energie. Eine Batterie hat den Vorteil, in der Anschaffung günstig zu sein, kann aber dazu führen, dass bei höherem Strombedarf des Verbrauchers die Betriebskosten sich unvorteilhaft entwickeln. Eine Batterie ist demzufolge dann vorteilhaft, wenn der mit dem Thermogenerator zu betreibende Verbraucher einen sehr geringen Energiebedarf, bzw. Strombedarf aufweist. Für Verbraucher mit höherem Strombedarf ist die Verwendung eines Akkumulators vorteilhaft. Dieser speichert die aus der thermischen Energie gebildete elektrische Energie und gibt sie an den Verbraucher ab. Alternativ ist auch ein kapazitives elektrisches Bauteil als elektrischer Energiespeicher verwendbar. Dieser ist praktisch von beliebig langer Lebensdauer und unterliegt nicht, wie elektrochemische Speicher, einem Alterungsprozess. Somit ist der Verbraucher durch zwei Spannungsquellen parallel versorgbar. Der Verbraucher ist nicht ständig in Betrieb und kann auch verschiedene Betriebszustände mit unterschiedlich starkem Energiebedarf einnehmen. Ebenso ist die Menge der durch den thermoelektrischen Prozess erzeugten elektrischen Energie von der Menge der thermischen Energie abhängig. Nur im Idealfalle fällt der Verbrauch von elektrischer Energie mit der Erzeugung von elektrischer Energie zusammen. Somit ist es besonders vorteilhaft, wenn der Akkumulator überschüssige elektrische Energie speichert, die dann an den Verbraucher abgegeben werden kann, wenn die Menge der aus thermischer Energie gewandelten elektrischen Energie zum Betrieb des Verbrauchers nicht ausreichend ist.

Eine vorteilhafte Ausführungsform des Thermogenerators ist dadurch gebildet, dass die zweite elektrische Spannungsquelle aus einem Wiegant- oder einem Impulsdraht-Element gebildet ist.

Ein Wiegant- oder Impulsdraht-Element ist ein magnetfeldsensitives Bauelement welches eine Änderung eines magnetischen Feldes in ein elektrisches Signal wandelt, beziehungsweise magnetische Energie in elektrische Energie wandelt. Die Wandlung von magnetischer Energie in elektrische Energie durch das Wiegant- oder Impulsdraht-Element ist bedingt durch Form- oder Kristallanisotropien, so dass sich nur ein einziger Weißscher Bezirk ausbilden kann. Wiegant- oder ImpulsdrahtElemente, haben fast rechteckig ausgebildete Hysteresekurven. Die Remanenz der Wiegant- oder Impulsdrahtelemente ist nur unwesentlich kleiner als deren Sättigungsmagnetisierung. Wenn ein äußeres Magnetfeld die Koerzitivfeldstärke des Wiegant- oder Impulsdrahtelements überschreitet, springt die Magnetisierung spontan um und nimmt einen entgegengerichteten gleichen Betrag an. Wenn sich der magnetische Werkstoff innerhalb einer Induktionsspule befindet, wird in diese eine erhebliche Spannung induziert, da die Sättigungsmagnetisierung sehr groß ist und damit eine Veränderung der Sättigungsinduktionsflussdichte eintritt, welche innerhalb kurzer Zeit erfolgt. Wiegand- und Impulsdrahtsensoren können aufgrund der genannten Eigenschaften eine Änderung äußerer Magnetfelder in digitaler Form anzeigen, beziehungsweise eine Änderung äußerer Magnetfelder in elektrische Energie wandeln. Ausgangsmaterial für Wiegant- oder Impulsdrahtsensoren sind Drähte, die eine Formanisotropie aufgrund eines lang gestreckten Aufbaus besitzen. Die Formanisotropie ist durch Anlegen einer Zugspannung noch verstärkbar. Wiegant- oder Impulsdrahtsensoren bilden somit eigene Spannungsquellen und arbeiten berührungs- und kontaktlos in einem Temperaturbereich von ca. 200 °C bis +200 °C.

In der Spule welche um einen Wiegant- oder Impulsdraht-Element gewickelt ist, werden Spannungsimpulse erzeugt, die sich problemlos und störungsfrei über lange Strecken übertragen lassen. Vorteile eines Wiegand- und Impulsdraht-Elementes sind eine direkte Verwendbarkeit eine in diesem Element gebildeten Ausgangssignals ohne zusätzliche Verstärkung, eine weitgehende Unabhängigkeit von der vorherrschenden Umgebungstemperatur und auch eine Unabhängigkeit von der Geschwindigkeit der Magnetfeldänderung.

In der vorteilhaften Ausführungsform mit dem Wiegant- oder Impulsdrahtelement ist dieses mit der ersten Spannungsquelle so gekoppelt, dass eine Spule mit der Spannung der ersten Spannungsquelle beaufschlagt ist. In der Spule ändert sich durch eine Änderung der Spannung ein durch die Spule gebildetes Magnetfeld. Mit steigender Spannung steigen der Strom durch die Spule und damit der magnetische Fluss des gebildeten Magnetfeldes. Steigt der magnetische Fluss solange an, bis er die Koerzitivfeldstärke übersteigt, springt die Magnetisierung des Wiegant- oder Impulsdraht-Elementes spontan um und erzeugt einer Spule des Wiegant- oder Impulsdraht-Elementes eine hohe elektrische Spannung. Alternativ ist zu einer optimierten Kopplung des Magnetfelds der Spule mit dem Wiegant- oder Impulsdrahtelement ist ein Weicheisenkern vorgesehen. Die hohe elektrische Spannung, welche durch das Wiegant- oder Impulsdraht-Element erzeugt ist wird dem ersten Speicherelement oder dem Verbraucher zugeführt.

Eine vorteilhafte Ausführungsform des Thermogenerators ist dadurch gebildet, dass die zweite elektrische Spannungsquelle aus einem Halbleiter-Spannungsvervielfacher gebildet ist. Der Halbleiter-Spannungsvervielfacher ist mit der ersten Spannungsquelle so gekoppelt, dass ein Spannungseingang des Halbleiter-Spannungsvervielfachers mit dem Spannungsausgang der ersten Spannungsquelle gekoppelt ist. Der Halbleiter-spannungsvervielfacher ist ein Oszillator, der bereits ab sehr geringen Spannungen zu schwingen beginnt. Dabei findet ein Transistor, zum Beispiel ein Germanium Transistor, mit niedriger Schwellspannung Verwendung. Dieser ist mit einer Primärwicklung eines Transformators so gekoppelt, dass zu Beginn der Transistor leitend ist, so dass sich in der Primärwicklung ein Magnetfeld aufbaut. Über eine Sekundärwicklung des Transformators wird dabei eine entgegengesetzte Spannung induziert, welche zu einem Schließen den Transistor führt. In diesem Moment bricht das Magnetfeld der Primärwicklung zusammen, und der Vorgang beginnt von neuem. Dabei ist eine Vervielfachung der Eingangsspannung erreichbar. Die daraus resultierende höhere elektrische Spannung wird dem ersten Speicherelement oder dem Verbraucher zugeführt.

In einer alternativen Ausführungsform des Thermogenerators ist die zweite elektrische Spannungsquelle aus einem zweiten thermoelektrischen Element gebildet. Damit lassen sich unterschiedliche Eigenschaften thermoelektrischer Elemente vorteilhaft kombinieren. So ist zum Beispiel ein Peltier-Element mit einem pyroelektrischen Element kombinierbar. Damit wird nicht nur ein räumlicher Temperaturgradient eines Körpers thermisch in elektrische Energie gewandelt, sondern auch durch eine zeitliche Änderung der Temperatur des Körpers ist thermische Energie in elektrische Energie wandelbar.

Es ist in einer weiteren alternativen Ausführungsform die zweite elektrische Spannungsquelle aus einer Kombination, zum Beispiel einer Parallelschaltung eines zweiten thermoelektrischen Elements mit dem ersten elektrischen Speicherelement gebildet. Damit sind die bereits genannten Vorteile nochmals um den Vorteil der Speicherung überschüssiger elektrischer Energie erweitert. Es ergibt sich demnach mit der Kombination des ersten thermoelektrischen Elements mit dem zweiten thermoelektrischen Element und dem ersten Speicherelement ein Thermogenerator, welcher verschiedene thermoelektrische Prozesse und deren Eigenschaften vorteilhaft kombiniert und darüber hinaus die überschüssige, vom Verbraucher nicht benötigte elektrische Energie in dem ersten elektrischen Speicherelement speichert. Durch die Speicherung ist die elektrische Energie auch dann dem Verbraucher zuführbar, wenn keine thermische Energie zur Wandlung in elektrische Energie zur Verfügung steht.

In einer weiteren vorteilhaften Ausführungsform ist vorgeschlagen, eine der oben genannten alternativen Ausführungsformen dadurch vorteilhaft zu erweitern, dass ein zweites elektrisches Speicherelement mit dem Spannungsausgang des Thermogenerators verbunden ist. Wahlweise eignet sich auch hierzu eine Batterie, oder ein Akkumulator zur Speicherung von elektrischer Energie. Eine Batterie hat auch hier den Vorteil, in der Anschaffung günstig zu sein, kann aber auch hier dazu führen, dass bei höherem Strombedarf des Verbrauchers die Betriebskosten sich unvorteilhaft entwickeln. Eine Batterie ist demzufolge auch hier besonders dann vorteilhaft, wenn der mit dem Thermogenerator zu betreibende Verbraucher einen sehr geringen Energiebedarf, beziehungsweise Strombedarf aufweist. Für Verbraucher mit höherem Strombedarf ist die Verwendung eines Akkumulators auch hier vorteilhaft. Dieser speichert die aus der thermischen Energie gebildete elektrische Energie und gibt sie an den Verbraucher ab. Alternativ ist auch hier ein kapazitives elektrisches Bauteil als elektrischer Energiespeicher verwendbar. Dieser ist praktisch von beliebiger Lebensdauer und unterliegt nicht, wie elektrochemische Speicher, einem Alterungsprozess. Das zweite elektrische Speicherelement ist besonders für jene alternative Ausführungsform vorteilhaft, die aus zwei thermoelektrischen Elementen gebildet ist und keinen elektrischen Energiespeicher aufweist. Somit ist der Verbraucher durch verschiedene Spannungsquellen versorgbar, wodurch für verschiedene Betriebszustände des Thermogenerators und damit auch der thermischen Energiequelle eine Versorgung mit elektrischer Energie für den Verbraucher herstellbar ist. Der Verbraucher ist nicht ständig in Betrieb und kann auch verschiedene Betriebszustände mit unterschiedlich starkem Energiebedarf einnehmen. Ebenso ist die Menge der durch den thermoelektrischen Prozess erzeugten elektrischen Energie von der Menge der thermischen Energie abhängig. Nur im Idealfalle fällt der Verbrauch von elektrischer Energie mit der Erzeugung von elektrischer Energie zusammen. Somit ist es besonders vorteilhaft, wenn der Akkumulator überschüssige elektrische Energie speichert, die dann an den Verbraucher abgegeben werden kann, wenn die Menge der aus thermischer Energie gewandelten elektrischen Energie zum Betrieb des Verbrauchers nicht ausreichend ist.

Es ist vorteilhaft, die erste elektrische Spannungsquelle aus einem auf einen räumlichen Temperaturgradienten empfindlichen thermoelektrischen Element zu bilden. Weiter ist es vorteilhaft, das zweite thermoelektrische Element oder die zweite Spannungsquelle aus einem auf eine Temperaturänderung empfindlichen Element zu bilden. Diese Elemente sind mit dem Körper thermisch koppelbar. Die thermische Kopplung zwischen dem Körper und den thermoelektrischen Elementen kann in verschiedenen Ausführungsformen umgesetzt sein. Beispielhaft bietet sich die thermische Kopplung durch eine Wärmeleitpaste an, welche zwischen dem Körper und den thermoelektrischen Elementen angebracht ist und diese mit den Körpern thermisch koppelt, andererseits ist auch möglich, die thermische Kopplung durch so genannte Heatpipes, zum Beispiel durch ein Wärme übertragendes Medium und eine Rohrleitung, in denen dieses Medium fließt, herzustellen. Die Verwendung einer Wärmeleitpaste setzt voraus, dass der Thermogenerator an dem Körper in geeigneter Weise angeordnet beziehungsweise befestigt ist.

Findet ein Thermoelement, welches auf einen räumlichen Temperaturgradienten empfindlich ist und aufgrund des räumlichen Temperaturgradienten thermische Energie in elektrische Energie wandelt, als erste Spannungsquelle Verwendung, ist es vorteilhaft, mittels eines Kühlkörpers den räumlichen Temperaturgradienten zu erhöhen. Dabei sollte der Kühlkörper an der dem Körper gegenüberliegenden Seite oder Fläche des Thermoelements angeordnet sein.

Es ist weiter vorteilhaft, einen Spannungswandler vorzusehen, der einen ersten Spannungseingang aufweist, welcher mit dem ersten Spannungsausgang verbunden ist und einen zweiten Spannungseingang aufweist, welcher mit dem zweiten Spannungsausgang verbunden ist. Der Spannungswandler ist dabei dazu eingerichtet, an seinem dritten Spannungsausgang ein von dem ersten Spannungseingang verschiedenes Spannungsniveau abzugeben. Damit ist erreichbar, dass Spannungsniveaus, die das vom Verbraucher benötigte Niveau unterschreiten, auf ein höheres Niveau wandelbar sind. Ebenso sind Spannungsniveaus, die das vom Verbraucher benötigte Niveau überschreiten, auf ein niedrigeres Niveau wandelbar. Unabhängig von der durch die Thermoelemente gelieferten Spannung ist somit eine für den Verbraucher geeignete elektrische Spannung herstellbar.

In einer vorteilhaften Ausführungsform ist eine Wandlerschaltung vorgesehen, welche das Spannungsniveau des ersten Spannungseingangs auf ein höheres Spannungsniveau an einem Ausgang der Wandlerschaltung wandelt. Darüber hinaus ist eine Strombegrenzungseinrichtung vorgesehen, welche dem Ausgang der Wandlerschaltung und dem dritten Spannungsausgang zwischengeschaltet ist. Die Strombegrenzungseinrichtung begrenzt dabei den Ausgangsstrom des Thermogenerators auf einen vorbestimmbaren Wert. Dieser Wert ist so ausgewählt, dass der Spannungswandler durch die Stromabnahme des Verbrauchers nicht überlastet wird. Weiter vorteilhaft ist, dass die Strombegrenzungseinrichtung in Abhängigkeit von den Eingangssignalen des ersten Spannungseingangs des Spannungswandlers steuerbar ist. Damit ist zum einen vermeidbar, dass der Spannungswandler aufgrund zu hoher Stromentnahme nicht mehr betriebsfähig ist. Zum anderen ist damit erreichbar, dass die Stromentnahme nicht in größerem Maße als notwendig begrenzt wird.

Es ist vorteilhaft, die Wandlerschaltung als eine Halbleiterschaltung gemäß eines Schaltwandlers auszubilden. Halbleiterschaltungen als Wandlerschaltung weisen gegenüber elektromechanischen Wandlerschaltungen einen höheren Wirkungsgrad auf. Der höhere Wirkungsgrad ist insbesondere bei den zu erwartenden geringen elektrischen Spannungen oder elektrischen Strömen von großer Bedeutung, da möglichst wenig elektrische Energie durch den Prozess der Spannungswandlung gebunden werden soll.

Wandlerschaltungen, die als Halbleiterschaltung ausgeführt sind, benötigen, um den Prozess der Spannungswandlung einzuleiten, eine Mindestspannung von ungefähr 0,3 V. Diese Mindestspannung, im Folgenden als Schwellspannung bezeichnet, wird in einer vorteilhaften Ausführungsform durch eine Startvorrichtung bereitgestellt. Diese Startvorrichtung ist mit dem zweiten Spannungseingang des Spannungswandlers verbunden, und wandelt das Spannungssignal des zweiten Spannungseingangs zu einem Startsignal. Mit dem zweiten Spannungseingang des Spannungswandlers ist wie vorgehend beschrieben die zweite Spannungsquelle verbunden, welche durch ein pyroelektrisches Element gebildet ist. Verändert sich die Temperatur des Körpers, so erzeugt das pyroelektrische Element ein Spannungssignal, welches größer als 1 Volt ist. Dieses Spannungssignal wird der Startvorrichtung zugeführt und dort zu dem Startsignal gewandelt. Das Startsignal wird der Wandlerschaltung zugeführt, wobei die Spannung des Startsignals größer ist als die Schwellspannung der Halbleiterschaltung. Die elektrischen Spannungen, die durch pyroelektrische Elemente erzeugt werden, sind sehr hoch und können weit mehr als 1 Volt betragen. Um Schäden an den Halbleiterbauteilen der Wandlerschaltung durch sehr hohe Spannungen zu vermeiden, ist die Startvorrichtung dazu eingerichtet, das Spannungsniveau des Startsignals auf die erforderliche Schwellspannung begrenzen zu können.

Verändert sich die Temperatur des Körpers nicht und ist dennoch ein räumlicher Temperaturgradient vorhanden, der eine Wandlung von thermischer Energie in elektrische Energie ermöglicht, so wird alleine durch die elektrische Spannung, die das Peltier-Element erzeugt, die Schwellspannung nicht überschritten, denn das Spannungsniveau des Peltier-Elements ist geringer als die Schwellspannung. Um in einem solchem Betriebszustand des Thermogenerators dennoch die am Peltier-Element anliegende elektrische Spannung auf ein höheres Niveau zu wandeln, ist es somit vorteilhaft, einen Zeitgeber vorzusehen, mittels dem wiederkehrend der Startvorrichtung ein Signal zuführbar ist, von dessen Abhängigkeit ein Startsignal ausgelöst wird. Dabei ist es weiter von Vorteil, wenn der Zeitgeber an dem ersten und/oder zweiten elektrischen Speicherelement angeschlossen ist, dessen gespeicherte Ladung dazu verwendbar ist, der Startvorrichtung ein Signal zuzuführen.

Somit ist auch ein Thermogenerator vorgeschlagen mit einem auf einen räumlichen Temperaturgradienten empfindlichen ersten thermoelektrischen Element und einem auf eine Temperaturänderung empfindlichen zweiten thermoelektrischen Element. Die beiden thermoelektrischen Elemente sind mit einem Körper thermisch koppelbar. Das auf den Temperaturgrandienten empfindliche erste thermoelektrische Element weist einen ersten Spannungsausgang auf, der an einen ersten Spannungswandlereingang eines Spannungswandlers angeschlossen ist. Zudem weist das auf die Temperaturänderung empfindliche zweite thermoelektrische Element einen zweiten Spannungsausgang auf, der an einen zweiten Spannungswandlereingang des Spannungswandlers angeschlossen ist. An dem dritten Spannungsausgang ist ein elektrischer Verbraucher anschließbar. Der Spannungswandler wandelt dabei die Spannung des ersten Spannungswandlereingangs auf ein zum ersten Spannungswandlereingang verschiedenes höheres Niveau um, welches am Spannungswandlerausgang und damit am dritten Spannungsausgang anliegt.

Es ist vorteilhaft, das auf die Temperaturänderung empfindliche zweite thermoelektrische Element als ein pyroelektrisches Element auszuführen und das auf den Temperaturgradienten empfindliche erste thermoelektrische Element als ein Peltier-Element auszuführen. Das pyroelektrische Element nutzt dabei die Eigenschaft von pyroelektrischen Kristallen oder pyroelektrischen Keramiken und ist demzufolge aus einem solchen Kristall oder eine solchen Keramik gefertigt, wobei der Kristall oder die Keramik bei Temperaturänderungen ein elektrisches Feld erzeugt. Dieser pyroelektrischer Effekt erzeugt Spannungen, die weit größer als 1 V sind und deshalb auch dazu geeignet sind, die Schwellspannung einer halbleiterbasierten Wandlerschaltung zu überwinden.

Um die Halbleiterschaltung nicht durch zu hohe Spannungen, welche durch das pyroelektrische Element generiert werden, zu zerstören, ist an dem zweiten Spannungseingang des Spannungswandlers oder an den zweiten Spannungsausgang des zweiten thermoelektrischen Elementes eine Einrichtung vorgesehen, die die Spannung auf ein vorbestimmbares Maximalniveau begrenzt.

Mittels der thermischen Kopplung wird den thermoelektrischen Elementen Wärmeenergie zugeführt, welche eine elektrische Spannung in Abhängigkeit von der Wärmeenergie erzeugt. Mittels des Spannungswandlers wird eine von dem auf den räumlichen Temperaturgradienten empfindlichen ersten thermoelektrischen Element erzeugte elektrische Spannung auf ein zu dieser Spannung höheres Niveau gewandelt.

Mittels des pyroelektrischen Elementes beziehungsweise des auf Temperaturänderung empfindlichen zweiten thermoelektrischen Elementes wird nunmehr die Schwellspannung des halbleiterbasierten Spannungswandlers überwunden. Die halbleiterbasierte Wandlerschaltung wandelt das durch den Temperaturgradienten erzeugte Spannungssignal auf ein höheres Niveau.

Als Beispiel eines Körpers, dessen Wärme beziehungsweise Abwärme zur Wandlung von thermischer Energie in elektrische Energie heranziehbar ist, sei eine Verbrennungskraftmaschine genannt. Diese ist beim Startvorgang der Maschine kalt, und kann auch in den Sekunden danach noch als kalt bezeichnet werden. Bei längerer Betriebsdauer erwärmt sich die Maschine kontinuierlich, bis sie eine weitgehend gleich bleibende Temperatur erreicht hat. Während des Erwärmens dient die durch das auf die Temperaturänderung empfindliche erste thermoelektrische Element erreichte Spannung dem Überwinden der Schwellspannung an der Wandlerschaltung. Beim Erreichen eines Temperaturniveaus, das gegenüber der Umgebungstemperatur höher ist, wird der Temperaturgradient mittels des auf den räumlichen Temperaturgradienten empfindlichen zweiten thermoelektrischen Elements in eine elektrische Spannung gewandelt, welche dem Spannungswandlereingang zugeführt wird.

Die Startvorrichtung ist verbunden mit dem zweiten Spannungswandlerausgang und mit der Wandlerschaltung, wobei die Aktivierung der Wandlerschaltung durch Signale aus der Startvorrichtung erfolgt. Liegt zum Beispiel ein hohes Spannungseingangssignal am zweiten Spannungseingang des Spannungswandlers an, wird die Energie zur Überwindung der Schwellspannung und zum Starten der Wandlerschaltung diesem Eingang entnommen. Liegt allerdings an diesem Eingang nicht ausreichend Energie in Form von elektrischer Spannung an, so wird mittels eines Zeitgebers in wiederkehrender Weise oder in periodischen Abständen ein Signal an die Startvorrichtung übermittelt, wobei diese mit der dieses Signal beinhaltenden Energie die Schwellspannung des Spannungswandlerschalters überwindet und somit ein Startsignal für die Wandlerschaltung gebildet ist. Das Startsignal beinhaltet nicht nur die Information zum Start der Wandlerschaltung, sondern auch die Energie zum kurzzeitigen Betrieb der Wandlerschaltung. Das Startsignal hält solange an, bis die Wandlerschaltung aus der Energie der ersten Spannungsquelle ausreichend versorgt ist.

Der Zeitgeber erhält seine Energie aus der ersten oder der zweiten Speichereinrichtung, welche die elektrische Energie, welche die Wandlerschaltung verlässt, speichert. Diese Speichereinrichtung ist ein Ladungsspeicher, der als kapazitives Element oder als elektrochemischer Ladungsspeicher ausführbar ist.

Als Wandlerschaltung ist ein Gleichspannungswandler als Aufwärtswandler vorgesehen, welcher ein Spannungseingangssignal auf ein höheres Spannungsniveau wandelt. Dies wird erreicht, in dem der Stromfluss durch eine Spule in periodischen Abständen unterbrochen wird und damit induktiv an der Spule ein höheres Spannungssignal als das Eingangssignal am Spannungswandler erzeugt wird. Durch die Ausführung als Halbleiterschaltung wird dieses Unterbrechen des Stromflusses durch Halbleiterbauelemente, zum Beispiel Transistoren, bewirkt, welche unter der Schwellspannung von ungefähr 0,3 V nicht schalten.

Es ist weiter zur Lösung der Aufgabe ein Verfahren vorgeschlagen, bei dem zur Wandlung von thermischer Energie in elektrische Energie mittels eines ersten thermoelektrischen Elements elektrische Spannung erzeugt wird, und bei dem mittels einer zweiten Spannungsquelle elektrische Spannung vorliegt, welche dann einem Verbraucher zuführbar ist, wenn die Spannung des ersten thermoelektrischen Elements einen vorbestimmbaren Wert unterschreitet. Damit ist vorteilhaft für zwei sich wesentlich unterscheidende Zustände der Wärmequelle sichergestellt, dass dem Verbraucher elektrische Energie dann zur Verfügung steht, wenn dessen Betriebszustand dies erfordert. Die beiden sich wesentlich unterscheidenden Betriebszustände der Wärmequelle sind zum Beispiel das Vorhandensein eines höheren Temperaturniveaus der Wärmequelle gegenüber der Umgebung oder aber das Fehlen eines Temperaturunterschieds der Wärmequelle gegenüber der Umgebung. Kann aufgrund fehlender thermischer Energie keine elektrische Energie gewandelt werden, so wird die elektrische Energie für den Betrieb des Verbrauchers der zweiten Spannungsquelle entnommen. Die zweite Spannungsquelle kann dabei auch ein elektrisches Speicherelement sein, welches elektrische Energie zwischenspeichert.

Eine vorteilhafte Ausführungsform des Verfahrens sieht vor, die elektrische Spannung der zweiten Spannungsquelle durch ein einen magnetoelektrischen Prozess eines formanisotropen Werkstoffes zu erzeugen. Formanisotrope Werkstoffe haben die Eigenschaft, nur einen Weisschen Bezirk auszubilden. Das bewirkt, dass bei einem Überschreiten eines äußeren Magnetfeldes, welches auf den formanisotropen Werkstoff wirkt, dieser Weissche Bezirk spontan umschlägt, wobei eine hohe Spannung ein einer den formanisotropen Werkstoff umgebenden Spule erzeugt wird. Somit wirkt der formanisotrope Werkstoff in Kombination mit der ihn umgebenen Spule als eine eigene Spannungsquelle.

Eine vorteilhafte Ausführungsform des Verfahrens sieht vor, die elektrische Spannung der zweiten Spannungsquelle durch einen thermoelektrischen Prozess zu bilden. Damit ist die Versorgung des Verbrauchers mit elektrischer Energie vorteilhaft auf die Wärmequelle abstimmbar.

Zudem ist es vorteilhaft, wenn dem thermoelektrischen Prozess ein pyroelektrischer Effekt zugrunde liegt. Mittels eines pyroelektrischen Prozess lässt sich nicht nur eine absolute Temperatur, oder ein Temperaturgradient, wie das bei Thermoelementen der Fall ist, in elektrisch Energie wandeln, sondern es lässt sich bereits eine Temperaturänderung in elektrische Energie wandeln.

Eine weitere vorteilhafte Ausführungsform des Verfahrens sieht vor, mittels einer Wandlerschaltung die elektrische Spannung des ersten thermoelektrischen Elements auf ein höheres Spannungsniveau zu wandeln. Damit ist erreichbar, dass Spannungsniveaus, die das vom Verbraucher benötigte Niveau unterschreiten, auf ein höheres Niveau wandelbar sind. Ebenso sind Spannungsniveaus, die das vom Verbraucher benötigte Niveau überschreiten, auf ein niedrigeres Niveau wandelbar. Unabhängig von dem durch die Thermoelemente gelieferte Spannung ist somit eine für den Verbraucher geeignete elektrische Spannung herstellbar.

Wandlerschaltungen, insbesondere halbleiterbasierte Wandlerschaltungen benötigen, um den Prozess der Spannungswandlung einzuleiten, eine Schwellspannung von ungefähr 0,3 V. Dabei ist es vorteilhaft, diese Schwellspannung durch eine Startvorrichtung bereit zu stellen. Die Startvorrichtung wandelt das Spannungssignal des zweiten thermoelektrischen Elements in ein Startsignal, welches die Wandlerschaltung aktiviert. Ist die Wandlerschaltung aktiviert, so arbeitet diese auch mit Spannungen unterhalb der Schwellspannung. Besonders vorteilhaft ist diese Verfahrensweise dann, wenn mittels eines pyroelektrischen Effekts ein Spannungssignal erzeugt wird, welches dem Startsignal zugrunde liegt.

Um den Prozess der Spannungswandlung nicht zu überlasten und durch zu hohe elektrische Stromentnahmen seitens des Verbrauchers zu stoppen, ist es vorteilhaft, die dem Verbraucher zugeführte Stromstärke in Abhängigkeit von der Eingangsspannung der Wandlerschaltung zu begrenzen. Die Eingangsspannung der Wandlerschaltung ist somit eine elektrische Größe welche von dem ersten thermoelektrischen Element gebildet ist.

Die Wärmequelle kann einen Betriebszustand einnehmen, der zwar ein höheres Temperaturniveau gegenüber der Umgebung aufweist, dabei aber die absolute Temperatur nicht ändert. Ist in einem solchen Betriebszustand der Wärmequelle, die Wandlerschaltung nicht in Betrieb, reicht die erzeugte elektrische Spannung möglicherweise auch nicht aus, um die Schwellspannung der Wandlerschaltung zu überschreiten. Aufgrund der gleich bleibenden Temperatur wird durch den pyroelektrischen Prozess auch keine Spannung erzeugt, die der Startvorrichtung zugeführt und damit das Startsignal erzeugt werden kann. Um dies zu umgehen, sieht eine vorteilhafte Ausführungsform des Verfahrens vor, der Startvorrichtung ein wiederkehrendes Signal zuzuführen, in dessen Abhängigkeit ein Startsignal erzeugt wird. Um das Signal in einer wiederkehrenden Weise oder auch periodisch, zu erzeugen, ist die Verwendung eines Zeitgebers vorteilhaft, welcher die elektrische Energie zum Betrieb und die elektrische Energie für das Startsignal einer elektrischen Speichereinrichtung entnimmt.

Um thermische Energie in elektrische Energie zu wandeln, ist es vorteilhaft, die Wärmeenergie einem Körper zu entnehmen, welcher zum Beispiel durch Arbeitsprozesse Wärme entwickelt. Um die Wärme dieses Körpers zu nutzen, beziehungsweise in elektrische Energie zu wandeln, ist es vorteilhaft, diesem mit den zur Wandlung von thermischer in elektrische Energie vorgesehenen Elementen thermisch zu koppeln. Die thermische Kopplung kann in verschiedenen Ausführungsformen umgesetzt sein. Beispielhaft bietet sich an, die thermische Kopplung durch eine Wärmeleitpaste, welche zwischen dem Körper und den thermoelektrischen Elementen angebracht ist und diese mit den Körpern thermisch koppelt, andererseits ist auch möglich, die thermische Kopplung durch so genannte Heatpipes, zum Beispiel durch ein Wärme übertragendes Medium und Rohrleitung, in denen dieses Medium fließt, herzustellen.

Nachfolgend wird die Erfindung unter Zuhilfenahme von sieben Figuren näher erläutert. Es zeigen:
- Figur 1: ein herkömmliches Ausführungsbeispiel mit einem thermoelektrischen Element,
- Figur 2: ein herkömmliches Ausführungsbeispiel mit zwei thermoelektrischen Elementen,
- Figur 3: ein herkömmliches Ausführungsbeispiel mit einem thermoelektrischen Element und Spannungswandler,
- Figur 4: ein herkömmliches Ausführungsbeispiel mit zwei thermoelektrischen Elementen und Spannungswandler,
- Figur 5: ein herkömmliches Ausführungsbeispiel mit zwei thermoelektrischen Elementen und Spannungswandler,
- Figur 6: ein Ausführungsbeispiel gemäß der Erfindung mit zwei thermoelektrischen Elementen und Spannungswandler mit Startvorrichtung, und
- Figur 7: ein Ausführungsbeispiel gemäß der Erfindung mit Wiegant- oder Impulsdraht-Element als zweite Spannungsquelle, und
- Figur 8: ein Ausführungsbeispiel gemäß der Erfindung mit einem Halbleiter-Spannungsvervielfacher als zweite Spannungsquelle, und
- Figur 9: ein Ausführungsbeispiel eines Halbleiter-Spannungsvervielfachers zur erfindungsgemäßen Verwendung.

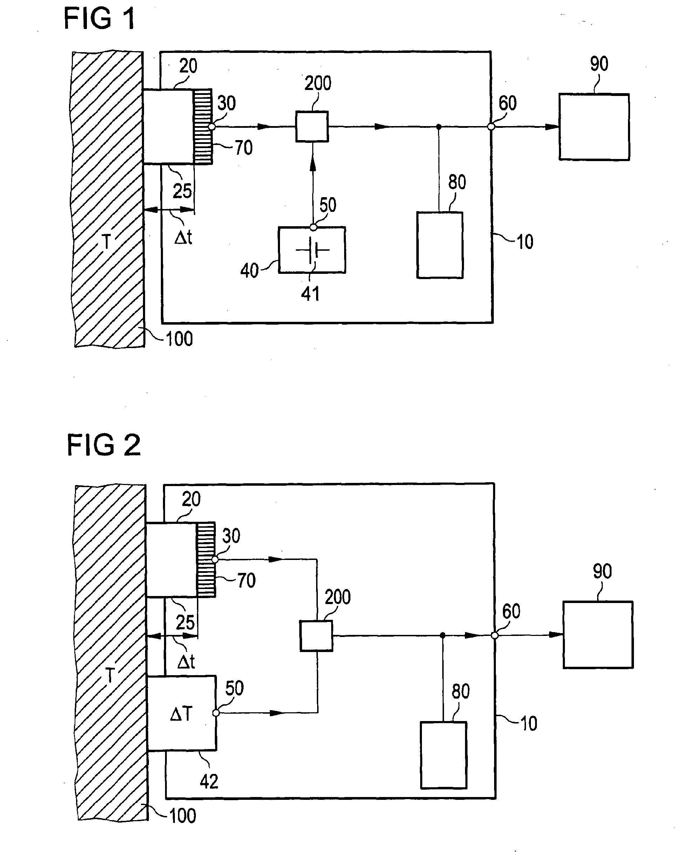

Die Figur 1 zeigt ein herkömmliches Ausführungsbeispiel, bei dem ein Thermogenerator 10 mit einer ersten Spannungsquelle 20 versehen ist. Die erste Spannungsquelle 20 ist als ein erstes thermoelektrisches Element 25 ausgebildet und weist einen ersten Spannungsausgang 30 auf. Der Spannungsausgang 30 ist über eine Entkopplungseinrichtung 200 gekoppelt mit dem Spannungsausgang 60 des Thermogenerators. Eine zweite elektrische Spannungsquelle 40 ist vorgesehen, für die Betriebszustände, in denen die erste Spannungsquelle 20 beziehungsweise das erste thermoelektrische Element 25 keine Spannung liefert. In diesem Fall wird der Spannungsbedarf beziehungsweise der elektrische Energiebedarf am Spannungsausgang 60 durch die zweite elektrische Spannungsquelle 40, die zum Beispiel ein erstes elektrisches Speicherelement 41 umfasst, gedeckt. Dazu ist ein zweiter Spannungsausgang 50, welcher an der zweiten elektrischen Spannungsquelle 40/41 angeordnet ist, über die Entkopplungseinrichtung 200 mit dem Spannungsausgang 60 der Thermogenerators gekoppelt.

Die Entkopplungseinrichtung 200 verhindert, dass die beiden Spannungsquellen 20/40 sich gegenseitig ungewollt speisen, und somit die Spannung am Spannungsausgang 60 von dem Betriebszustand der jeweils inaktiven Spannungsquelle abhängig ist. Die Entkopplungseinrichtung 200 umfasst dazu zum Beispiel ein Halbleiterelement wie eine Diode, oder einen Transistor, der die beiden Spannungsquellen entkoppelt. Alternativ umfasst die Entkopplungseinrichtung ein elektromechanisches Schaltelement, das in Abhängigkeit von den Betriebszuständen der einzelnen Spannungsquellen die erste oder die zweite Spannungsquelle mit dem Ausgang 60 des Thermogenerators verbindet.

Als erstes elektrisches Speicherelement 41 sind wahlweise elektrochemische Speicherelemente oder kapazitive Speicherelemente verwendbar. Im Falle von elektrochemischen Speicherelementen sind entweder Akkumulatoren oder Batterien verwendbar, wobei in Abhängigkeit des Einsatzzweckes entweder Akkumulatoren oder Batterien vorteilhaft sind. Insbesondere dann, wenn der Energiebedarf des Verbrauchers 90 im Wesentlichen durch die elektrische Energie, die das erste thermoelektrische Element liefert, zu decken ist, ist möglicherweise eine Batterie als elektrisches Speicherelement günstiger als ein Akkumulator, der höhere Anschaffungskosten verursacht.

Alternativ ist ein zweites elektrisches Speicherelement 80 vorgesehen, welches überschüssige Energie, die das erste thermoelektrische Element 25 liefert und nicht unmittelbar durch den Verbraucher 90 konsumiert wird, zwischenspeichert und für den Betriebszustand vorhält, an dem die elektrische Energie, die durch das erste thermoelektrische Element 25 geliefert wird, nicht zum Betrieb des Verbrauchers ausreichen würde. Zur Übergabe von thermischer Energie von einem Körper 100 ist das erste thermoelektrische Element 25 mit diesem Körper 100 thermisch gekoppelt. In dem Ausführungsbeispiel ist diese thermische Kopplung durch eine unmittelbare Verbindung beziehungsweise Montage des thermoelektrischen Elementes 25 und damit auch des Thermogenerators 10 an dem Körper 100 bewerkstelligt.

Die Figur 2 zeigt eine herkömmliche Ausführungsform, bei der gegenüber der Ausführungsform nach Figur 1 die zweite Spannungsquelle durch ein zweites thermoelektrisches Element 42 gebildet ist. Vorzugsweise ist dieses thermoelektrische Element 42 als ein thermoelektrisches Element, welches auf eine Temperaturänderung anspricht, gebildet. Beispielsweise ein pyroelektrisches Element. Pyroelektrische Elemente erzeugen elektrische Energie in Abhängigkeit von einer Temperaturänderung, diese Energie wird am zweiten Spannungsausgang 50 des zweiten thermoelektrischen Elements 42 zur Verfügung stehen. Das zweite thermoelektrische Element 42 ist zu diesem Zweck ebenso wie das erste thermoelektrische Element 25 mit dem Körper 100 thermisch gekoppelt. Dazu ist auch das zweite thermoelektrische Element 42 an den Körper 100 direkt angeordnet, so dass ein unmittelbarer Wärmeübergang von dem Körper 100 zu den thermoelektrischen Elementen 25 und 42 gegeben ist. Vorzugsweise ist das erste thermoelektrische Element 25 durch ein Peltier-Element gebildet. Die jeweiligen Ausgänge 30 und 50 der thermoelektrischen Elemente sind jeweils gekoppelt mit dem Ausgang 60 des Thermogenerators, an welchem der Verbraucher 90 angeschlossen ist. Somit ist für viele Betriebszustände eine Versorgung des Verbrauchers 90 realisiert. Für Betriebszustände in denen weder das Peltier-Element durch einen Temperaturgradienten Δt noch das pyroelektrische Element durch eine Änderung der Temperatur ΔT ei ne Spannung liefert, ist auch hier das zweite elektrische Speicherelement 80 vorgesehen, um diese Bedarfslücke mit zwischengespeicherter elektrischer Energie an den Ausgang 60 zu übergeben und damit zu decken.

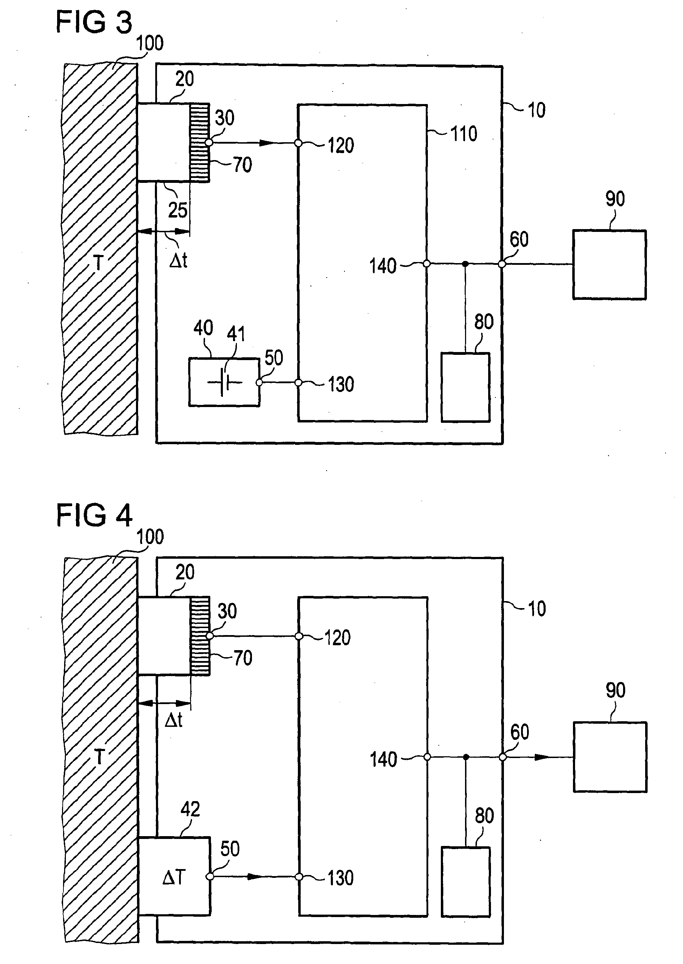

Die Figur 3 zeigt eine herkömmliche Ausführungsform, bei der der Thermogenerator einen Spannungswandler 110 umfasst, welcher einen ersten Spannungseingang 120 und einen zweiten Spannungseingang 130 aufweist. Der erste Spannungseingang ist verbunden mit dem ersten thermoelektrischen Element 25, welches über den ersten Spannungsausgang 30 elektrische Spannung an den ersten Spannungseingang 120 übergibt. Der Spannungswandler 110 ist dazu eingerichtet, das Spannungssignal, welches am ersten Spannungseingang 120 anliegt auf ein dazu höheres Niveau zu wandeln und diese Spannung am Spannungswandlerausgang 140 bereitzustellen. Die zweite elektrische Spannungsquelle 40 beinhaltet das erste elektrische Speicherelement 41, dessen zweiter Spannungsausgang 50 mit dem zweiten Spannungseingang 130 des Spannungswandlers 110 verbunden ist. Ist der Temperaturgradient Δt zu gering, um Spannungen am ersten thermoelektrischen Element 25 zu generieren, so wird die in dem elektrischen Speicherelement 41 gespeicherte elektrische Energie dem zweiten Spannungseingang 130 des Spannungswandlers 110 zugeführt. Mit dem Spannungswandlerausgang 140 ist das zweite elektrische Speicherelement 80 verbunden, um überschüssige elektrische Energie, welche nicht durch den Verbraucher 90 benötigt wird, zwischenzuspeichern. Auch in diesem Ausführungsbeispiel ist das erste thermoelektrische Element 25 mit dem Körper 100 durch thermische Kopplung verbunden, so dass die Wärmeenergie von dem Körper 100 auf das Thermoelement übergeht. Auch in diesem Ausführungsbeispiel ist ein Kühlkörper 70 an dem Thermoelement angeordnet, so dass der Temperaturgradient über das erste thermo elektrische Element 25 beziehungsweise das Peltier-Element erhöht werden kann.

Die Figur 4 zeigt ein herkömmliches Ausführungsbeispiel in einer vorteilhaften Ausführungsform, wobei gegenüber der Ausführungsform in der Figur 3 die zweite Spannungsquelle durch ein zweites thermoelektrisches Element 42 gebildet ist. Dieses zweite thermoelektrische Element 42 ist ein auf eine Temperaturänderung empfindliches thermoelektrisches Element wie zum Beispiel ein pyroelektrisches Element.

Vorteilhaft an dieser Ausführungsform ist, dass für verschiedene Betriebszustände des Körpers 100 elektrische Spannung beziehungsweise elektrische Energie gewandelt werden kann. Der Spannungswandler 110 stellt aus den Eingängen der beiden Spannungseingänge am Ausgang beziehungsweise am Spannungswandlerausgang 140 das von dem elektrischen Verbraucher 90 benötigte Spannungsniveau zur Verfügung.

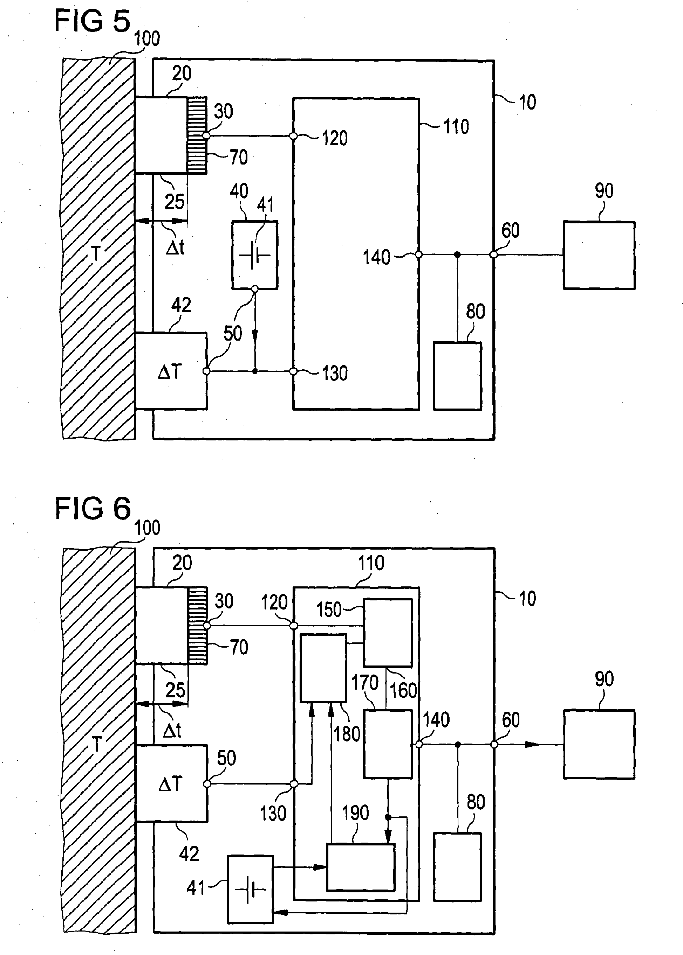

Die Figur 5 zeigt eine vorteilhafte herkömmliche Ausführungsform, bei der die zweite Spannungsquelle durch eine Kombination beziehungsweise Parallelschaltung des ersten elektrischen Speicherelements 41 und des zweiten thermoelektrischen Elements 42 gebildet ist. Somit stellt also das erste elektrische Speicherelement 41, zum Beispiel in Form eines elektrochemischen Speicherelements wie Batterie oder Akkumulator, für einen Betriebszustand gleich bleibender Temperatur am Körper 100 Spannung zum Betrieb des Spannungswandler 110 am Eingang des Spannungswandler 130 zur Verfügung.

Es zeigt die Figur 6 eine besonders vorteilhafte Ausführungsform gemäß der Erfindung, bei der der Spannungswandler 110 eine Wandlerschaltung 150 umfasst, welche mit dem ersten Spannungseingang 120 gekoppelt ist. Die Wandlerschaltung 150 wandelt das Spannungsniveau des Spannungseingangs 120 auf ein gegenüber diesem höheres Niveau und stellt dies am Ausgang 160 der Wandlerschaltung zur Verfügung. Der Ausgang der Wandlerschaltung 160 ist über eine Strombegrenzungseinrichtung 170 mit dem Ausgang 140 des Spannungswandlers und darüber mit dem Ausgang 60 des Thermogenerators verbunden. Die Strombegrenzungseinrichtung 170 bewirkt eine Begrenzung der abgegebenen Stromstärke in einer Abhängigkeit von dem am ersten Spannungseingang 120 anliegenden Spannungssignal oder Stromstärke.

Damit verhindert die Strombegrenzungseinrichtung 170 eine Überbelastung der Wandlerschaltung 150, welche zum Stillstand des Wandlungsprozesses in der Wandlerschaltung 150 führen würde.

Die Wandlerschaltung 150 ist vorteilhaft als Halbleiterwandlerschaltung ausgeführt. Das heißt, um den Betrieb der Wandlerschaltung 150 zu starten, ist eine Schwellspannung der Wandlerschaltung zumindest zu überwinden, die in Form eines Startsignals der Wandlerschaltung zugeführt wird.

Das erfindungsgemäße Ausführungsbeispiel der Figur 6 sieht für das Generieren eines Startsignals zwei Varianten vor. Eine Variante ist dadurch gebildet, dass das pyroelektrische Element 42 ein Spannungssignal, welches die Schwellspannung in den meisten Fällen überschreitet, durch eine Temperaturänderung generiert wird. Dieses Spannungssignal wird über den zweiten Spannungseingang 130, welcher hochohmig ausgeführt ist, der Startvorrichtung 180 zugeführt, welche aus diesem Spannungssignal ein Startsignal generiert und dies an die Wandlerschaltung 150 übergibt. Zusätzlich verhindert die Startvorrichtung ein Zerstören der Wandlerschaltung durch Überspannung, da Überspannungen mittels der Startvorrichtung von der Wandlerschaltung 150 ferngehalten werden. Somit lässt sich ein Startvorgang zur Wandlung thermischer Energie in elektrische Energie wie folgt beschreiben. Der Körper 100 erwärmt sich langsam, so dass mit der Zeit ein räumlicher Temperaturgradient Δt am Peltier-Element 25 anliegt. Während der Temperaturänderung generiert das pyroelektrische Element eine elektrische Spannung an dessen Spannungsausgang 50, welcher über den zweiten Spannungseingang 130 der Startvorrichtung 180 zugeführt wird. Die Startvorrichtung 180 generiert aus diesem Spannungssignal ein Startsignal und übergibt dies der Wandlerschaltung 150. Die Wandlerschaltung erhält mit dem Startsignal Betriebsenergie und beginnt daraufhin den Spannungswandlerprozess zu starten und wandelt das durch den Temperaturgradienten Δt am Peltier-Element gebildete Spannungssignal, welches am ersten Spannungseingang 120 des Spannungswandlers anliegt. Der Spannungsausgang ist in diesem Ausführungsbeispiel niederohmig ausgeführt. Das von einem Peltier-Element in der Regel niedrige Spannungssignal wird auf ein höheres Niveau gewandelt und über die Strombegrenzungseinrichtung 170 am dritten Spannungsausgang 60, welcher der Spannungsausgang des Thermogenerators ist, dem Verbraucher 90 zur Verfügung gestellt.

Ist der Prozess der Spannungswandlung aus welchem Grund auch immer gestoppt und besteht ein räumlicher Temperaturgradient Δt am Peltier-Element 25, so kann es sein, dass die Spannung am ersten Spannungseingang des Spannungswandlers 110 nicht ausreicht, um in der Wandlerschaltung die Schwellspannung zu überschreiten. Für diesen Betriebszustand ist ein Zeitgeber 190 vorgesehen, der die zu seinem Betrieb erforderliche elektrische Energie dem Speicherelement 41 oder dem Speicherelement 80 entnimmt. Das Speicherelement 41 oder das Speicherelement 80, welches als elektrochemisches oder kapazitives Speicherelement ausgeführt ist, erhält seine Energie ebenfalls über die Strombegrenzungseinrichtung 170 aus der Wandlerschaltung 150. Für eine alternative Ausführungsform, wobei als Speicherelement 41 eine Batterie vorgesehen ist, ist keine Lieferung von elektrischer Energie an das Speicherelement vorgesehen. Das Speicherelement liefert die für den Zeitgeber notwendige Betriebsenergie sowie die Energie, um ein Startsignal zu generieren. Der Zeitgeber 190 sendet wiederkehrend oder in periodischen Zeitabständen ein Signal an die Startvorrichtung 180, wobei in Abhängigkeit von diesem Signal die Startvorrichtung 180 ein Startsignal generiert und an die Wandlerschaltung 150 übermittelt. Das heißt, solange der Wandler keine Spannung liefert wird periodisch oder wiederkehrend durch den Zeitgeber 190 ein Startsignal generiert und an die Wandlerschaltung 150 übermittelt, welche dann in Folge des Startsignals den Wandlungsprozess der Spannungswandlung einleiten kann.

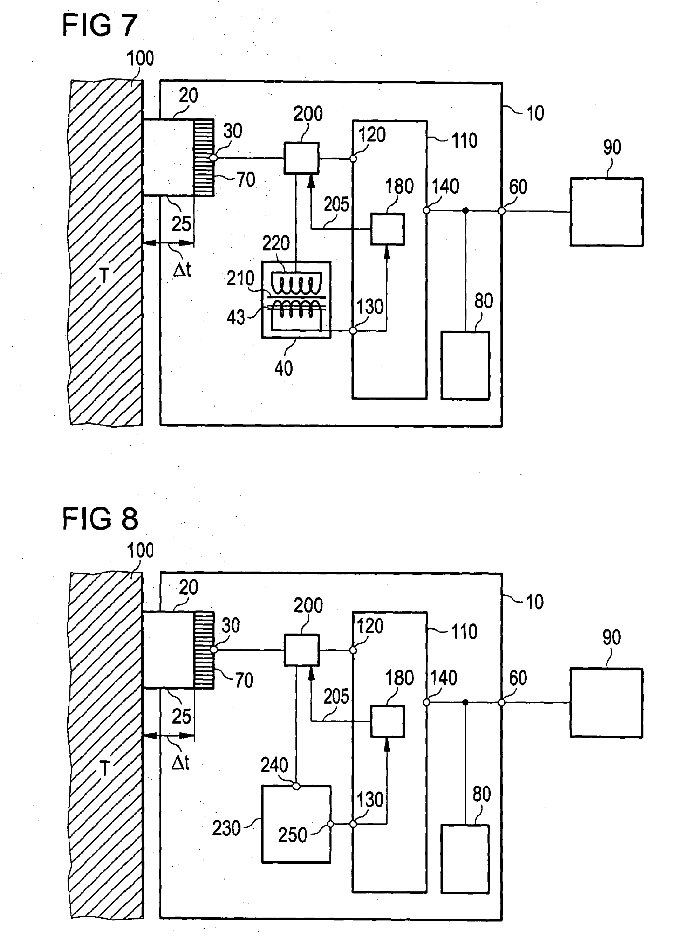

Die Figur 7 zeigt ein Ausführungsbeispiel der Erfindung, bei dem ein Wiegant- oder ein Impulsdraht-Element 43 die zweite Spannungsquelle bildet. Das Wiegant- oder Impulsdraht-Element ist über die Entkopplungseinrichtung 200 so mit der ersten Spannungsquelle, dem ersten thermoelektrischen Element 25 gekoppelt, dass die durch die erste Spannungsquelle erzeugte Spannung eine Spule 220 speist. Die Spule 220 bildet in Abhängigkeit von der durch das thermoelektrische Element 25 erzeugten Spannung ein magnetisches Feld aus. Mit steigender Spannung an dem ersten thermoelektrischen Element 25 steigt somit auch die Spannung an der Spule 220 und damit ebenso die Flussdichte des durch die Spule 220 gebildeten magnetischen Feldes. Mittels eines Weicheisenkerns 210 ist dieses magnetische Feld in optimierter Weise in das Wiegant- oder Impulsdraht-Element 43 eingekoppelt. Mit dem Erreichen eines vorbestimmten Wertes des magnetischen Flusses springt die Magnetisierung des Wiegant- oder Impulsdrahtelementes 43 spontan um und erzeugt innerhalb des Wiegant- oder Impulsdrahtelementes 43 einen elektrischen Spannungsimpuls von mehreren Volt. Diese Spannung wird dem Spannungswandler 110 am Eingang 130 zugeführt. Dieser Spannungsimpuls wird im Spannungswandler 130 einer weiteren Verarbeitung zugeführt. Die weitere Verarbeitung des durch das Wiegant- oder Impulsdrahtelement 43 erzeugten Spannungsimpulses sieht zum Beispiel vor, die Startvorrichtung 180 zu speisen und damit ein Startsignal zu erzeugen, welches der Spannungswandlerschaltung 180 zugeführt wird. Ebenso, wie in dem in Figur 6 beschriebenen Ausführungsbeispiel, überwindet das Startsignal in der Spannungswandlerschaltung 180 die Schwellspannung der halbleiterbasierten Spannungswandlerschaltung 180. Auch die weitere Funktionsweise des Spannungswandlers 110 entspricht dem in der Figur 6 beschriebenen Ausführungsbeispiel.

Es besteht bei dem Spannungswandler 110 des erfindungsgemäßen Ausführungsbeispiels aus der Figur 7 wahlweise ein Unterschied darin, dass parallel zu dem Startsignal ein Steuerimpuls an die Entkopplungseinrichtung übermittelt wird, welcher in der Entkopplungseinrichtung bewirkt, dass das Wiegant- oder Impulsdraht-Element 43 von dem ersten thermoelektrischen Element entkoppelt wird. Dies ist besonders deshalb vorteilhaft, da dann die Spule 220 in einem Betriebszustand in dem die Spannungswandlerschaltung arbeitet, keine zusätzliche elektrische Energie dem ersten thermoelektrischen Element 25 entzieht, und damit alle erzeugte elektrische Energie des ersten thermoelektrischen Elementes 25 der Spannungswandlung in der Spannungswandlerschaltung 180 zugeführt wird.

Figur 8 zeigt ein Ausführungsbeispiel der Erfindung, bei dem ein Halbleiter-Spannungsvervielfacher 230 die zweite Spannungsquelle bildet. Der Halbleiter-Spannungsvervielfacher 230 ist über die Entkopplungseinrichtung 200 so mit der ersten Spannungsquelle, dem ersten thermoelektrischen Element 25 gekoppelt, dass die durch die erste Spannungsquelle erzeugte Spannung einen Schaltungseingang 240 des Halbleiter-Spannungsvervielfachers speist. Der Halbleiter-Spannungsvervielfacher 230 ist ein Oszillator, der bereits ab sehr geringen Spannungen zu schwingen beginnt und an einem Ausgang 250 eine Vervielfachung der Eingangsspannung erreichbar. Diese Spannung wird dem Spannungswandler 110 am Eingang 130 zugeführt. Dieser Spannungsimpuls wird im Spannungswandler 130 einer weiteren Verarbeitung zugeführt. Die weitere Verarbeitung der durch den Halbleiter-Spannungsvervielfacher 230 erzeugten Spannung sieht zum Beispiel vor, die Startvorrichtung 180 zu speisen und damit ein Startsignal zu erzeugen, welches der Spannungswandlerschaltung 180 zugeführt wird. Ebenso, wie in dem in Figur 6 beschriebenen Ausführungsbeispiel, überwindet das Startsignal in der Spannungswandlerschaltung 180 die Schwellspannung der halbleiterbasierten Spannungswandlerschaltung 180. Auch die weitere Funktionsweise des Spannungswandlers 110 entspricht dem in der Figur 6 beschriebenen Ausführungsbeispiel.

In dem erfindungsgemäßen Ausführungsbeispiel der Figur 8 ergeht, zum Beispiel parallel zu dem Startsignal, ein Steuerimpuls 205 an die Entkopplungseinrichtung 200. Der Steuerimpuls bewirkt in der Entkopplungseinrichtung, dass der Halbleiter-Spannungsvervielfacher 230 von dem ersten thermo elektrischen Element entkoppelt wird. Dies ist besonders deshalb vorteilhaft, da dann der Halbleiter-Spannungsvervielfacher 230 in einem Betriebszustand in dem die Spannungswandlerschaltung arbeitet, keine zusätzliche elektrische Energie dem ersten thermoelektrischen Element 25 entzieht, und damit alle erzeugte elektrische Energie des ersten thermoelektrischen Elementes 25 der Spannungswandlung in der Spannungswandlerschaltung 180 zugeführt wird.

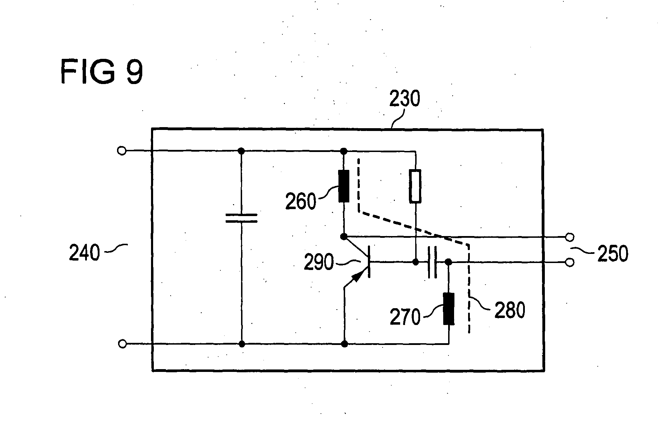

Figur 9 zeigt ein Beispiel des Halbleiter-Spannungsvervielfachers 230 zur erfindungsgemäßen Verwendung. Dabei ist ein Transformator vorgesehen, der eine Primärwicklung 260 und eine Sekundärwicklung 270 aufweist. Primär- und Sekundärwicklung sind mittels eines gemeinsamen Transformatorkerns 280 gekoppelt. Es ist ein Transistor 290 als Schaltelement vorgesehen. Um die Schwellspannung der Schaltung niedrig zu halten, eignet sich besonders ein Germanium-Transistor. Wird am Eingang 240 eine geringe Spannung angelegt, welche aber die Schwellspannung von ca. 60 mV - 100 mV übersteigt, so ist der Transistor in einem elektrisch leitenden Zustand, so dass die Primärwicklung 260 ein Magnetfeld aufbaut. Über die Sekundärwicklung baut sich, über die Kopplung des Transformatorkerns 280, ebenfalls ein Magnetfeld auf, welches eine Spannung an der Sekundärwicklung 270 induziert. Durch diese Spannung, welche an der Basis des Transistors 290 anliegt ändert der Transistor 290 seinen Schaltzustand und Sperrt den Stromfluss zwischen Kollektor und Emitter des Transistors 290. Damit bricht das Magnetfeld der Primärwicklung zusammen und erzeugt einen Spannungsimpuls von ungefähr 5 Volt zwischen Kollektor und Basis des Transistors 290. Der Transistor ist dann in Folge wieder leitend zwischen Kollektor und Emitter, und der Prozess beginnt von neuem.

### Bezugszeichenliste

- 10: Thermogenerator
- 20: erste elektrische Spannungsquelle
- 25: erstes thermoelektrisches Element
- 30: erster Spannungsausgang
- 40: zweite elektrische Spannungsquelle
- 41: erstes elektrisches Speicherelement
- 42: zweites thermoelektrisches Element
- 43: Wiegant- oder Impulsdraht-Element
- 50: zweiter Spannungsausgang
- 60: dritter Spannungsausgang (des Thermogenerators)
- 70: Kühlkörper
- 80: zweites elektrisches Speicherelement
- 90: elektrischer Verbraucher
- 100: Körper
- 110: Spannungswandler
- 120: erster Spannungseingang
- 130: zweiter Spannungseingang
- 140: Spannungswandlerausgang
- 150: Wandlerschaltung
- 160: Ausgang der Wandlerschaltung
- 170: Strombegrenzungseinrichtung
- 180: Startvorrichtung
- 190: Zeitgeber
- 200: Entkoppelungseinrichtung
- 205: Steuerimpuls
- 210: Weicheisenkern
- 220: Spule
- 230: Halbleiter-Spannungsvervielfacher
- 240: Spannungseingang Halbleiter-Spannungsvervielfacher
- 250: Spannungsausgang Halbleiter-Spannungsvervielfacher
- 260: Primärwicklung
- 270: Sekundärwicklung
- 280: Transformatorkern
- Δt: Temperaturgradient (räumlich)
- ΔT: Temperaturänderung (zeitlich)

## Patentansprüche

1. Thermogenerator mit
- einer ersten elektrischen Spannungsquelle (20), die aus einem ersten thermoelektrischen Element (25) gebildet ist, wobei die erste elektrische Spannungsquelle (20) einen ersten Spannungsausgang (30) aufweist,
- einer zweiten elektrischen Spannungsquelle (40) mit einem zweiten Spannungsausgang (50),
- einem dritten Spannungsausgang (60), der mit dem ersten Spannungsausgang (30) und dem zweiten Spannungsausgang (50) gekoppelt ist,
- einem Spannungswandler (110), der einen ersten Spannungseingang (120) aufweist, welcher mit dem ersten Spannungsausgang (30) verbunden ist und einen zweiten Spannungseingang (130) aufweist, welcher mit dem zweiten Spannungsausgang (50) verbunden ist, wobei der Spannungswandler (110) dazu eingerichtet ist, an einem Spannungswandlerausgang (140) ein vom ersten Spannungseingang (120) verschiedenes Spannungsniveau an den dritten Spannungsausgang (60) abzugeben, und
- einer Startvorrichtung (180) zum Starten des Spannungswandlers (110) über ein Startsignal, wobei die zweite elektrische Spannungsquelle (40) über ihren zweiten Spannungsausgang (50) die Startvorrichtung (180) betreibt.

2. Thermogenerator nach Anspruch 1, **dadurch gekennzeichnet, dass** der Spannungswandler (110)
- eine Wandlerschaltung (150) aufweist, welche das Spannungsniveau des ersten Spannungseingangs (120) auf ein höheres Spannungsniveau an einem Wandlerausgang (160) der Wandlerschaltung (150) wandelt, und
- eine Strombegrenzungseinrichtung (170) aufweist, welche dem Wandlerausgang (160) und dem dritten Spannungsausgang (60) des Thermogenerators (10) zwischengeschaltet ist.

3. Thermogenerator nach Anspruch 2, **dadurch gekennzeichnet, dass** die Startvorrichtung (180) mit dem zweiten Spannungseingang (130) des Spannungswandlers (110) verbunden ist und das Spannungssignal des zweiten Spannungseingangs (130) zu dem Startsignal wandelt, welches der Wandlerschaltung (150) zuführbar ist.

4. Thermogenerator nach Anspruch 3, **dadurch gekennzeichnet, dass** ein Zeitgeber (190) vorgesehen ist, mittels dem wiederkehrend der Startvorrichtung (180) ein Signal zuführbar ist, von dessen Abhängigkeit ein Startsignal ausgelöst wird.

5. Thermogenerator nach einem der Ansprüche 2 bis 4, **dadurch gekennzeichnet, dass** die Strombegrenzungseinrichtung (170) in Abhängigkeit von den Ausgangssignalen der ersten Spannungsquelle (20) steuerbar ist.

6. Thermogenerator nach einem der Ansprüche 2 bis 5, **dadurch gekennzeichnet, dass** die Wandlerschaltung (150) als eine integrierte Halbleiterschaltung ausgebildet ist.

7. Thermogenerator nach einem der Ansprüche 1 bis 6, **dadurch gekennzeichnet, dass** die zweite elektrische Spannungsquelle aus einem Halbleiter-Spannungsvervielfacher (230) gebildet ist.

8. Thermogenerator nach Anspruch 7, **dadurch gekennzeichnet, dass** der Halbleiter-Spannungsvervielfacher (230) über eine Entkoppelungseinrichtung (200) mit dem ersten Spannungsausgang (30) der ersten Spannungsquelle (20) koppelbar ist, so dass die durch die ersten Spannungsquelle (20) erzeugte Spannung einen Spannungseingang (240) des Halbleiter-Spannungsvervielfachers (230) speist.

9. Thermogenerator nach Anspruch 8, **dadurch gekennzeichnet, dass** vermittels der Startvorrichtung (180) ein Steuerimpuls (205) an die Entkoppelungseinrichtung (200) ergehen kann, wobei der Steuerimpuls (205) in der Entkoppelungseinrichtung (200) bewirkt, dass der Halbleiter-Spannungsvervielfacher (230) von der ersten Spannungsquelle (20) entkoppelt wird.

10. Thermogenerator nach einem der Ansprüche 1 bis 6, **dadurch gekennzeichnet, dass** die zweite elektrische Spannungsquelle aus einem zweiten thermoelektrischen Element (42) und/oder einem ersten elektrischen Speicherelement (41) gebildet ist.

11. Thermogenerator nach einem der Ansprüche 1 bis 6 oder 10, **dadurch gekennzeichnet, dass**
die zweite Spannungsquelle aus einem auf eine Temperaturänderung (ΔT) empfindlichen Element gebildet ist, welches derart ausgebildet ist, dass es mit einem Körper (100) thermisch koppelbar ist.

12. Thermogenerator nach einem der Ansprüche 1 bis 6, **dadurch gekennzeichnet, dass** die zweite elektrische Spannungsquelle aus einem Wiegant- oder einem Impulsdraht-Element (43) gebildet ist.

13. Thermogenerator nach Anspruch 10 oder 11, **dadurch gekennzeichnet, dass** das zweite thermoelektrische Element (42) aus einem pyroelektrischen Element gebildet ist.

14. Thermogenerator nach einem der Ansprüche 1 bis 13, **dadurch gekennzeichnet, dass** das erste thermoelektrische Element (25) aus einem auf einen Temperaturgradienten (Δt) empfindlichen thermoelektrischen Element gebildet ist, welches derart ausgebildet ist, dass es mit einem Körper (100) thermisch koppelbar ist.

15. Thermogenerator nach Anspruch 14, **dadurch gekennzeichnet, dass** das erste thermoelektrische Element (25) aus einem Peltier-Element gebildet ist.

16. Thermogenerator (10) nach Anspruch 14 oder 15, **dadurch gekennzeichnet, dass** ein Kühlkörper (70) an dem ersten thermoelektrischen Element (25) angeordnet ist.

17. Thermogenerator nach einem der Ansprüche 1 bis 16, **dadurch gekennzeichnet, dass** ein zweites elektrisches Speicherelement (80) mit dem dritten Spannungsausgang (60) gekoppelt ist.

18. Verfahren zur Wandlung von thermischer Energie in elektrische Energie, bei dem
- mittels eines ersten thermoelektrischen Elements (25) elektrische Spannung erzeugt wird,
- mittels einer Wandlerschaltung (150) die elektrische Spannung des ersten thermoelektrischen Elements (25) auf ein höheres Spannungsniveau gewandelt wird und
- mittels einer zweiten Spannungsquelle (40) elektrische Spannung zumindest zeitweise vorliegt,
**dadurch gekennzeichnet, dass**
mittels der zweiten Spannungsquelle (40) eine Startvorrichtung (180) betrieben wird, wobei die Startvorrichtung (180) ein Startsignal erzeugt, welches die Wandlerschaltung (150) aktiviert.

19. Verfahren nach Anspruch 18, **dadurch gekennzeichnet, dass** dem ersten thermoelektrischen Element (25) ein Peltier-Effekt zugrunde liegt.

20. Verfahren nach Anspruch 18 oder 19, **dadurch gekennzeichnet, dass** die elektrische Spannung durch einen Halbleiter-Spannungsvervielfacher (230) als zweite Spannungsquelle (40) erzeugt wird.

21. Verfahren nach Anspruch 18 oder 19, **dadurch gekennzeichnet, dass** die elektrische Spannung der zweiten Spannungsquelle (40) durch einen magnetoelektrischen Prozess eines formanisotropen Werkstoffes gebildet ist.

22. Verfahren nach Anspruch 18 oder 19, **dadurch gekennzeichnet, dass** die elektrische Spannung der zweiten Spannungsquelle (40) durch einen thermoelektrischen Prozess gebildet ist.

23. Verfahren nach Anspruch 22, **dadurch gekennzeichnet, dass** dem thermoelektrischen Prozess ein pyroelektrischer Effekt zugrunde liegt.

24. Verfahren nach einem der Ansprüche 18 bis 23, **dadurch gekennzeichnet, dass** die gewandelte elektrische Energie einem zweiten elektrischen Speicherelement (80) zugeführt wird.

25. Verfahren nach einem der Ansprüche 18 bis 24, **dadurch gekennzeichnet, dass** eine Stromstärke, welche einem Verbraucher (90) zugeführt wird, in Abhängigkeit von der durch das erste thermoelektrische Element (25) erzeugten elektrischen Größe begrenzt wird.

26. Verfahren nach einem der Ansprüche 18 bis 25, **dadurch gekennzeichnet, dass** der Startvorrichtung (180) ein wiederkehrendes Signal zugeführt wird, in Abhängigkeit dessen das Startsignal erzeugt wird.

27. Verfahren nach Anspruch 26, **dadurch gekennzeichnet, dass** das wiederkehrende Signal in Abhängigkeit von einem Zeitgeber (190) erzeugt wird.

28. Verfahren nach Anspruch 27, **dadurch gekennzeichnet, dass** der Zeitgeber (190) die elektrische Energie zum Betrieb des Zeitgebers (190) und die elektrische Energie für das Startsignal aus einem ersten elektrischen Speicherelement (41) oder einem zweiten elektrischen Speicherelement (80) erhält.

29. Verfahren nach einem der Ansprüche 18 bis 28, **dadurch gekennzeichnet, dass** die thermische Energie einem Körper (100) entnommen wird, welcher mit dem ersten thermoelektrischen Element (25) gekoppelt ist.

30. Verfahren nach einem der Ansprüche 18 bis 29, **dadurch gekennzeichnet, dass** die thermische Energie einem Körper (100) entnommen wird, welcher mit dem ersten thermoelektrischen Element (25) und der zweiten Spannungsquelle (40) thermisch gekoppelt ist.

## Claims

1. Thermoelectric generator comprising
- a first electrical voltage source (20), which is formed from a first thermoelectric element (25), wherein the first electrical voltage source (20) has a first voltage output (30),
- a second electrical voltage source (40) comprising a second voltage output (50),
- a third voltage output (60), which is coupled to the first voltage output (30) and the second voltage output (50),
- a voltage transformer (110), which has a first voltage input (120), which is connected to the first voltage output (30), and has a second voltage input (130), which is connected to the second voltage output (50), wherein the voltage transformer (110) is designed to output a voltage level at a voltage transformer output (140) to the third voltage output (60) wherein the voltage level is different from the first voltage input (120), and
- a starting apparatus (180) for starting the voltage transformer (110) via a start signal, wherein the second electrical voltage source (40) operates the starting apparatus (180) via the second voltage output (50) of said electrical voltage source.

2. Thermoelectric generator according to Claim 1, **characterized in that** the voltage transformer (110) has
- a transformer circuit (150), which converts the voltage level of the first voltage input (120) to a higher voltage level at a transformer output (160) of the transformer circuit (150), and
- a current-limiting device (170), which is interposed between the transformer output (160) and the third voltage output (60) of the thermoelectric generator (10).

3. Thermoelectric generator according to Claim 2, **characterized in that** the starting apparatus (180) is connected to the second voltage input (130) of the voltage transformer (110) and converts the voltage signal of the second voltage input (130) into the start signal, which can be supplied to the transformer circuit (150).

4. Thermoelectric generator according to Claim 3, **characterized in that** a timer (190) is provided, by means of which a signal can be supplied recurrently to the starting apparatus (180) with a start signal being initiated depending on said signal.

5. Thermoelectric generator according to one of Claims 2 to 4, **characterized in that** the current-limiting device (170) is controllable depending on the output signals of the first voltage signal (20).

6. Thermoelectric generator according to one of Claims 2 to 5, **characterized in that** the transformer circuit (150) is in the form of an integrated semiconductor circuit.

7. Thermoelectric generator according to one of Claims 1 to 6, **characterized in that** the second electrical voltage source is formed from a semiconductor voltage multiplier (230).

8. Thermoelectric generator according to Claim 7, **characterized in that** the semiconductor voltage multiplier (230) can be coupled to the first voltage output (30) of the first voltage source (20) via a decoupling device (200), so that the voltage generated by the first voltage source (20) feeds a voltage input (240) of the semiconductor voltage multiplier (230).

9. Thermoelectric generator according to Claim 8, **characterized in that** a control pulse (205) can be issued to the decoupling device (200) by means of the starting apparatus (180), wherein the control pulse (205) effects, in the decoupling device (200), that the semiconductor voltage multiplier (230) is decoupled from the first voltage source (20).

10. Thermoelectric generator according to one of Claims 1 to 6, **characterized in that** the second electrical voltage source is formed from a second thermoelectric element (42) and/or a first electrical storage element (41).

11. Thermoelectric generator according to one of Claims 1 to 6 or 10, **characterized in that** the second voltage source is formed from an element which is sensitive to a change in temperature (ΔT) and which is designed in such a way that it can be coupled thermally to a body (100).

12. Thermoelectric generator according to one of Claims 1 to 6, **characterized in that** the second electrical voltage source is formed from a Wiegand-wire or a pulse-wire element (43).

13. Thermoelectric generator according to Claim 10 or 11, **characterized in that** the second thermoelectric element (42) is formed from a pyroelectric element.

14. Thermoelectric generator according to one of Claims 1 to 13, **characterized in that** the first thermoelectric element (25) is formed from a thermoelectric element which is sensitive to a temperature gradient (Δt) and which is designed in such a way that it can be coupled thermally to a body (100).

15. Thermoelectric generator according to Claim 14, **characterized in that** the first thermoelectric element (25) is formed from a Peltier element.

16. Thermoelectric generator (10) according to Claim 14 or 15, **characterized in that** a heat sink (70) is arranged on the first thermoelectric element (25).

17. Thermoelectric generator according to one of Claims 1 to 16, **characterized in that** a second electrical storage element (80) is coupled to the third voltage output (60).

18. Method for converting thermal energy into electrical energy, in which
- electric voltage is generated by means of a first thermoelectric element (25),
- the electric voltage of the first thermoelectric element (25) is transformed to a higher voltage level by means of a transformer circuit (150), and
- electric voltage is present at least temporarily by means of a second voltage source (40),
**characterized in that**
a starting apparatus (180) is operated by means of the second voltage source (40), wherein the starting apparatus (180) generates a start signal, which activates the transformer circuit (150).

19. Method according to Claim 18, **characterized in that** the first thermoelectric element (25) is based on a Peltier effect.

20. Method according to Claim 18 or 19, **characterized in that** the electric voltage is generated by a semiconductor voltage multiplier (230) as second voltage source (40).

21. Method according to Claim 18 or 19, **characterized in that** the electric voltage of the second voltage source (40) is formed by a magnetoelectric process of a form-anisotropic material.

22. Method according to Claim 18 or 19, **characterized in that** the electric voltage of the second voltage source (40) is formed by a thermoelectric process.

23. Method according to Claim 22, **characterized in that** the thermoelectric process is based on a pyroelectric effect.

24. Method according to one of Claims 18 to 23, **characterized in that** the converted electrical energy is supplied to a second electrical storage element (80).

25. Method according to one of Claims 18 to 24, **characterized in that** a current intensity which is supplied to a consumer (90) is limited depending on the electrical magnitude generated by the first thermoelectric element (25).

26. Method according to one of Claims 18 to 25, **characterized in that** a recurring signal is supplied to the starting apparatus (180), with the start signal being generated depending on said signal.

27. Method according to Claim 26, **characterized in that** the recurring signal is generated depending on a timer (190).

28. Method according to Claim 27, **characterized in that** the timer (190) receives the electrical energy for operating the timer (190) and the electrical energy for the start signal from a first electrical storage element (41) or a second electrical storage element (80).

29. Method according to one of Claims 18 to 28, **characterized in that** the thermal energy is drawn from a body (100), which is coupled to the first thermoelectric element (25).

30. Method according to one of Claims 18 to 29, **characterized in that** the thermal energy is drawn from a body (100), which is coupled thermally to the first thermoelectric element (25) and the second voltage source (40).

## Revendications

1. Thermogénérateur comprenant
- une première source de tension électrique (20) qui est constituée d'un premier élément thermoélectrique (25), la première source de tension électrique (20) possédant une première sortie de tension (30),
- une deuxième source de tension électrique (40) dotée d'une deuxième sortie de tension (50),
- une troisième sortie de tension (60) qui est connectée à la première sortie de tension (30) et à la deuxième sortie de tension (50),
- un convertisseur de tension (110), qui possède une première entrée de tension (120) qui est reliée à la première sortie de tension (30) et une deuxième entrée de tension (130) qui est reliée à la deuxième sortie de tension (50), le convertisseur de tension (110) étant conçu pour délivrer, sur une sortie de convertisseur de tension (140), un niveau de tension à la troisième sortie de tension (60), le niveau de tension étant différent de celui de la première entrée de tension (120), et
- un système de démarrage (180) destiné à démarrer le convertisseur de tension (110) par le biais d'un signal de démarrage, la deuxième source de tension électrique (40) faisant fonctionner le système de démarrage (180) par le biais de sa deuxième sortie de tension (50).

2. Thermogénérateur selon la revendication 1, **caractérisé en ce que** le convertisseur de tension (110)
- possède un circuit convertisseur (150) qui convertit le niveau de tension de la première entrée de tension (120) en un niveau de tension plus élevé sur une sortie de convertisseur (160) du circuit convertisseur (150), et
- possède un dispositif limiteur de courant (170) qui est branché entre la sortie de convertisseur (160) et la troisième sortie de tension (60) du thermogénérateur (10).

3. Thermogénérateur selon la revendication 2, **caractérisé en ce que** le système de démarrage (180) est relié à la deuxième entrée de tension (130) du convertisseur de tension (110) et convertit le signal de tension de la deuxième entrée de tension (130) en le signal de démarrage qui peut être acheminé au circuit convertisseur (150).

4. Thermogénérateur selon la revendication 3, **caractérisé en ce qu'**il est prévu un générateur d'horloge (190) à l'aide duquel un signal peut être acheminé de manière récurrente au système de démarrage (180), un signal de démarrage étant déclenché en fonction dudit signal.

5. Thermogénérateur selon l'une des revendications 2 à 4, **caractérisé en ce que** le dispositif limiteur de courant (170) peut être commandé en fonction des signaux de sortie de la première source de tension (20).

6. Thermogénérateur selon l'une des revendications 2 à 5, **caractérisé en ce que** le circuit convertisseur (150) est réalisé sous la forme d'un circuit semiconducteur intégré.

7. Thermogénérateur selon l'une des revendications 1 à 6, **caractérisé en ce que** la deuxième source de tension électrique est constituée d'un multiplicateur de tension semiconducteur (230).

8. Thermogénérateur selon la revendication 7, **caractérisé en ce que** le multiplicateur de tension semiconducteur (230) peut être connecté par le biais d'un dispositif de découplage (200) à la première sortie de tension (30) de la première source de tension (20), de sorte que la tension générée par la première source de tension (20) alimente une entrée de tension (240) du multiplicateur de tension semiconducteur (230).

9. Thermogénérateur selon la revendication 8, **caractérisé en ce qu'**une impulsion de commande (205) peut être adressée au dispositif de découplage (200) par l'intermédiaire du système de démarrage (180), l'impulsion de commande (205) ayant pour effet, dans le dispositif de découplage (200), que le multiplicateur de tension semiconducteur (230) est découplé de la première source de tension (20).

10. Thermogénérateur selon l'une des revendications 1 à 6, **caractérisé en ce que** la deuxième source de tension électrique est constituée d'un deuxième élément thermoélectrique (42) et/ou d'un premier élément accumulateur électrique (41).

11. Thermogénérateur selon l'une des revendications 1 à 6 ou 10, **caractérisé en ce que** la deuxième source de tension est constituée d'un élément sensible à une variation de température (ΔT), lequel est configuré de telle sorte qu'il peut être couplé thermiquement avec un corps (100).

12. Thermogénérateur selon l'une des revendications 1 à 6, **caractérisé en ce que** la deuxième source de tension électrique est constituée d'un élément de Wiegand ou à fil d'impulsion (43).

13. Thermogénérateur selon la revendication 10 ou 11, **caractérisé en ce que** le deuxième élément thermoélectrique (42) est constitué d'un élément pyroélectrique.

14. Thermogénérateur selon l'une des revendications 1 à 13, **caractérisé en ce que** le premier élément thermoélectrique (25) est constitué d'un élément thermoélectrique sensible à un gradient de température (Δt), lequel est configuré de telle sorte qu'il peut être couplé thermiquement avec un corps (100).

15. Thermogénérateur selon la revendication 14, **caractérisé en ce que** le premier élément thermoélectrique (25) est constitué d'un élément de Peltier.

16. Thermogénérateur (10) selon la revendication 14 ou 15, **caractérisé en ce qu'**un dissipateur de chaleur (70) est monté sur le premier élément thermoélectrique (25).

17. Thermogénérateur selon l'une des revendications 1 à 16, **caractérisé en ce qu'**un deuxième élément accumulateur électrique (80) est connecté à la troisième sortie de tension (60).

18. Procédé de conversion d'énergie thermique en énergie électrique, selon lequel
- une tension électrique est générée au moyen d'un premier élément thermoélectrique (25),
- la tension électrique du premier élément thermoélectrique (25) est convertie en un niveau de tension plus élevé au moyen d'un circuit convertisseur (150) et
- la tension électrique est présente au moins temporairement au moyen d'une deuxième source de tension (40),
**caractérisé en ce que**
un système de démarrage (180) est mis en fonctionnement au moyen de la deuxième source de tension (40), le système de démarrage (180) générant un signal de démarrage qui active le circuit convertisseur (150).

19. Procédé selon la revendication 18, **caractérisé en ce qu'**un élément de Peltier est à la base du premier élément thermoélectrique (25).

20. Procédé selon la revendication 18 ou 19, **caractérisé en ce que** la tension électrique est générée par un multiplicateur de tension semiconducteur (230) faisant office de deuxième source de tension (40).

21. Procédé selon la revendication 18 ou 19, **caractérisé en ce que** la tension électrique de la deuxième source de tension (40) est formée par un processus magnétoélectrique d'un matériau à anisotropie de forme.

22. Procédé selon la revendication 18 ou 19, **caractérisé en ce que** la tension électrique de la deuxième source de tension (40) est formée par un processus thermoélectrique.

23. Procédé selon la revendication 22, **caractérisé en ce qu'**un effet pyroélectrique est à la base du processus thermoélectrique.

24. Procédé selon l'une des revendications 18 à 23, **caractérisé en ce que** l'énergie électrique convertie est acheminée à un deuxième élément accumulateur électrique (80).

25. Procédé selon l'une des revendications 18 à 24, **caractérisé en ce qu'**une intensité de courant qui est acheminée à un consommateur (90) est limitée en fonction de la grandeur électrique générée par le premier élément thermoélectrique (25).

26. Procédé selon l'une des revendications 18 à 25, **caractérisé en ce qu'**au système de démarrage (180) est acheminé un signal récurrent en fonction duquel est généré le signal de démarrage.

27. Procédé selon la revendication 26, **caractérisé en ce que** le signal récurrent est généré en fonction d'un générateur d'horloge (190).

28. Procédé selon la revendication 27, **caractérisé en ce que** le générateur d'horloge (190) reçoit l'énergie électrique destinée au fonctionnement du générateur d'horloge (190) et l'énergie électrique pour le signal de démarrage de la part d'un premier élément accumulateur électrique (41) ou d'un deuxième élément accumulateur électrique (80).

29. Procédé selon l'une des revendications 18 à 28, **caractérisé en ce que** l'énergie thermique est prélevée d'un corps (100) qui est couplé avec le premier élément thermoélectrique (25).

30. Procédé selon l'une des revendications 18 à 29, **caractérisé en ce que** l'énergie thermique est prélevée d'un corps (100) qui est couplé thermiquement avec le premier élément thermoélectrique (25) et avec la deuxième source de tension (40).
